(19) European Patent Office — Europäisches Patentamt / European Patent Office / Office européen des brevets

(11) **EP 1 096 573 A2**

(12) **EUROPEAN PATENT APPLICATION**

(43) Date of publication:
**02.05.2001 Bulletin 2001/18**

(51) Int. Cl.[7]: **H01L 29/78**

(21) Application number: **00123563.9**

(22) Date of filing: **27.10.2000**

(84) Designated Contracting States:
**AT BE CH CY DE DK ES FI FR GB GR IE IT LI LU MC NL PT SE**
Designated Extension States:
**AL LT LV MK RO SI**

(30) Priority: **27.10.1999 US 428616**

(71) Applicant: **Intersil Corporation**
**Palm Bay, Florida 32905 (US)**

(72) Inventor: **Bhalla, Anup**
**Santa Clara, CA (US)**

(74) Representative:
**Neugebauer, Jürgen, Dipl.-Phys. et al**
**c/o Schroeter Fleuchaus Lehmann & Gallo,**
**Melchiorstrasse 42**
**81479 München (DE)**

(54) **Technique for minimizing gate charge and gate to drain capacitance in power MOS devices such as DMOS, IGBTs and MOSFETs**

(57)   A power MOS device is provided that reduces gate to drain capacitance $C_{GD}$ by (1) the use of thicker gate oxides of at least about .2 micro-meters; (2) using a terraced gate oxide; (3) etching out the polysilicon from the drain overlap area, so as to leave two smaller polysilicon regions substantially over the channel, but not in the area above the drain; or (4) etching a small section of the polysilicon beyond the channel region so as to leave three areas of polysilicon, two forming gates above the channel and the third being in the areas overlapping the drain.

**EP 1 096 573 A2**

**Description**

This invention relates to a power MOS device.

A MOS (metal oxide semiconductor) device is an electronic device that has a gate conducting layer that overlaps an insulating layer (usually silicon oxide) under which is the rest of semiconductor device. MOS technology may be found in MOS integrated circuits, MOS logic circuits, MOS capacitors, and MOS field effect transistors (MOSFETs). This invention relates to Power MOS devices such as IGBTs, MOSFETs and a type of MOSFET known as DMOS.

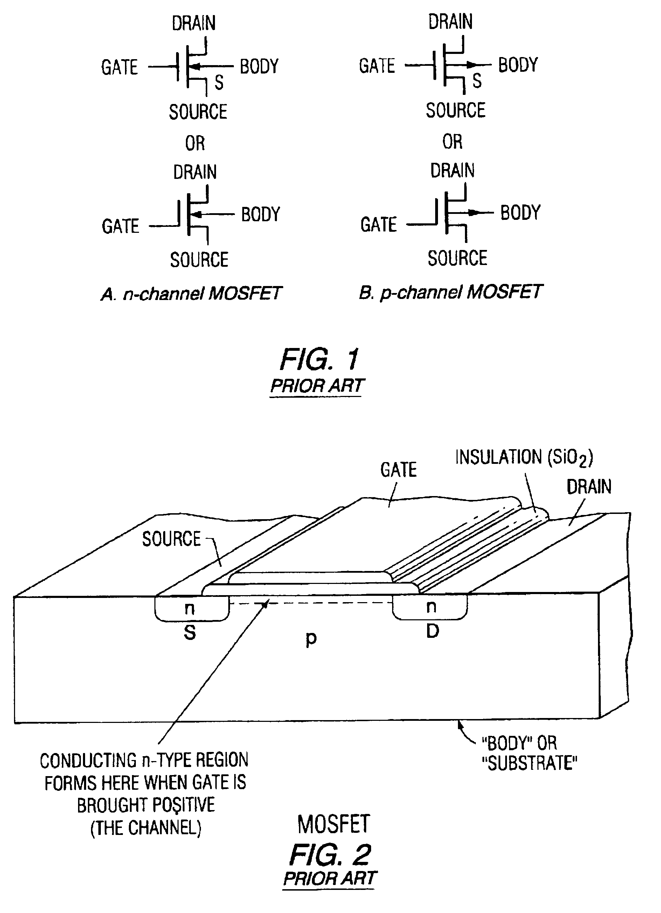

A "field effect transistor" (FET) is a unipolar, voltage controlled transistor. FETS, like the other major type of transistor (bipolar transistors), are used primarily for amplification (taking a signal and amplifying it) and switching (switching from an on/off state or between two discrete operating levels). The FET device is "unipolar" because its operation requires the movement of only one kind of charge carrier, electrons (through n-type doped silicon) or holes (through p-type doped silicon). Field effect transistors have three basic electrodes, a gate, a drain and a source. See Fig. 1 for a basic schematic diagram. The device is "voltage controlled" because current flowing between the source arid the drain is controlled by the voltage at the gate. Current moves in a channel of doped semiconductor (either n-doped or p-doped) between the source and drain. The application of a voltage to the gate electrode alters the conduction (i.e., resistance) of the channel, controlling the current that flows through the channel. Hence, a FET functions as a voltage-controlled variable resistor or switch. The term "field effect" is a reference to the fact that the conduction in a channel is controlled by an electric field, produced by the voltage applied to the gate. There are two basic types of FETS, JFETs (junction field effect transistors) and MOSFETs.

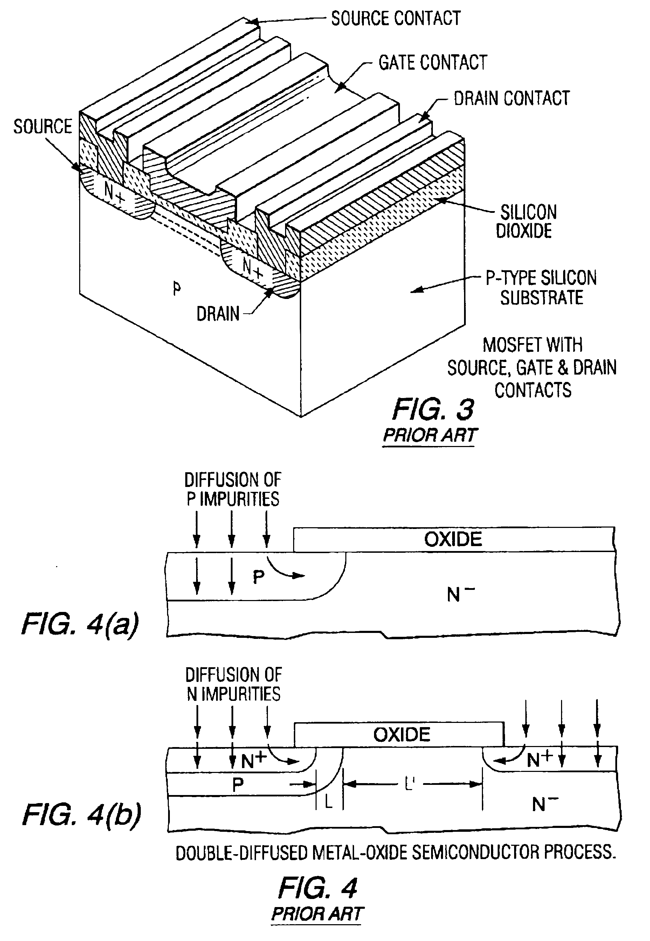

Fig. 2 shows a horizontal MOSFET (metal oxide semiconductor field effect transistor). A MOSFET is a type of field-effect transistor having a gate that is insulated from the rest of the semiconductor substrate (including the source-drain current of the channel) by a thin layer of silicon dioxide $(SiO)_2$, which acts as an insulator. For this reason, MOSFETS are also called "insulated-gate FETs" or "IGFETs." The gate to channel resistance is very high in a MOSFET, in the order of $10^{14}$ ohms. Fig. 3 shows another diagram of a horizontal MOSFET equipped with source, drain, and gate contacts. The gate electrode is made of a polycrystalline silicon, (also called colloquially as "polysilicon" or "poly" for short) The polycrystalline silicon is doped with a sufficiently high doping concentration so that it becomes conductive.

Whenever electrically charged conductors are separated by an insulating material (dielectric), a capacitance is formed. Capacitance is a measure of the ability to hold an electrical charge when a voltage is applied, and is the ratio of the charge one of the conductors of a capacitor (there being an equal and opposite charge on the other conductor) to the potential difference between the conductors, and may be determined by the formula: $C = q \div V$. FET switches exhibit a number of capacitances from one electrode to the other since these electrodes posses a certain amount of charge arid are separated by a voltage. These are known as "inter-electrode capacitances." There is a capacitance from the drain to the source ($C_{DS}$)(or input to output), and from gate to source ($C_{GS}$). Of particular concern is the capacitance from the gate electrode to the drain electrode ($C_{GD}$). These capacitances are unwanted parasitics. Those skilled in the art have long sought to remove them in order to improve the performance of MOSFETs.

A power MOSFET is a MOSFET capable of handling more than 1 ampere of current without damage or destruction. Power MOSFETs are used in high-frequency switching-regulated power supplies and motor controls. One type of power MOSFET is the DMOS transistor, which uses a technology called double diffusion. The diffusion process produces a junction by diffusing an impurity atom of one polarity into a semiconductor substrate. The semiconductor is raised to a high temperature in a gaseous atmosphere of the desired impurity. Double diffusion is a metal-oxide semiconductor process involving a two-stage diffusion (as opposed to the usual single diffusion) of impurities through a single mask opening. This process is shown in Fig. 4(a) whereby P impurities (or dopant) are diffused, and then in Fig. 4(b) where N impurities are diffused. This technique is used if very precise distances between junctions are required, as in DMOS circuits, since the geometry is defined by the diffusion process itself and errors caused by misalignment of successive photographic masks are eliminated. DMOS devices are short-channel high performance devices. The speed of an operation of an MOS transistor is determined by the channel length; for high operating speeds, short channels are required.

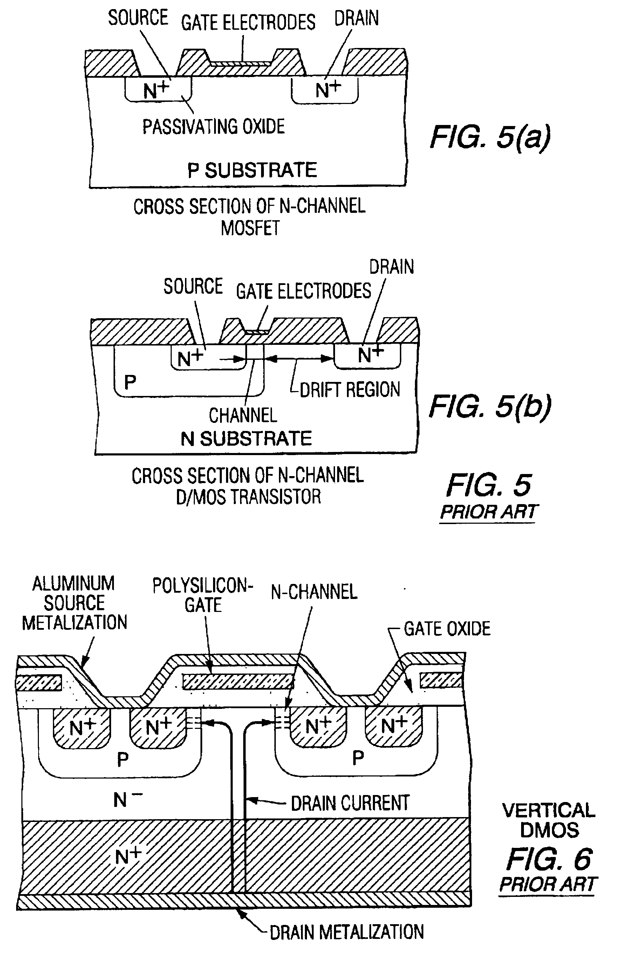

A horizontal n-channel DMOS (a DMOS where the channel is of n-type dopant) is shown in Fig. 5(b). It is to be contrasted with the horizontal n-channel MOSFET of Fig. 5(a). Fig. 6 shows a vertical DMOS device. It has its drain contact formed on the back of a semiconductor slice and current flows vertically through the device. Note the drain contact on the bottom, as opposed to its surface placement in a horizontal structure as shown in Fig. 5(a) or Fig. 2.

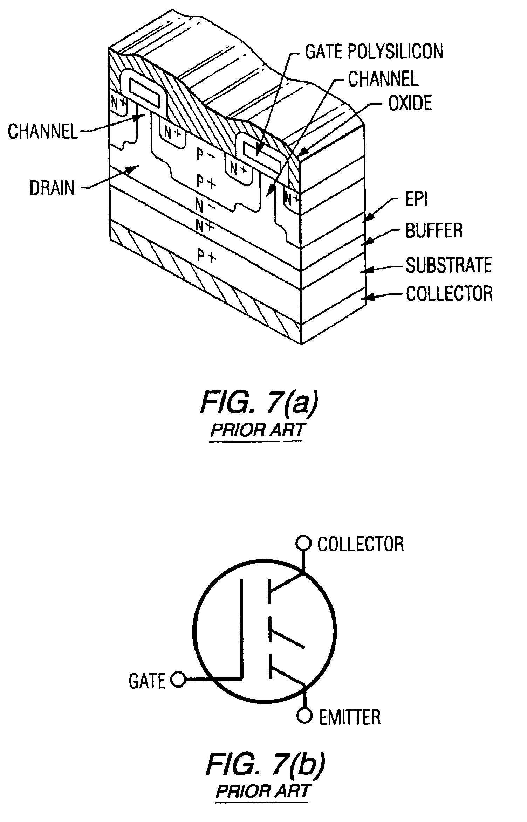

An IGBT (insulated gate bipolar transistor) is a four layer discrete power semiconductor device that combines the characteristics of a power MOSFET and a thyristor. It may be seen in Fig. 7. An IGBT is a vertical device because current flows vertically. A PNP bipolar transistor drives an N-channel MOSFET in a pseudo Darlington pair (a pair of bipolar junction transistors in which the emitter of the first transistor is connected to the base of the second transistor. This configuration provides far higher current gain than a single transistor through direct coupling). The P+ collector layer modifies the conductivity to increase conductance in the "on" state. This permits it to be used in circuits rated above 300 Volts. As to appearance, an IGBT has a cross-section similar to a MOSFET, except for its P+ substrate at the bottom, which cause the IGBT to function in away that is more similar to a bipolar transistor than to a power MOSFET. The P+ material forms a collector.

There is a long felt needto reduce the gate charge in power MOSFETS, IGBTs, and DMOS devices. Since capacitance (C) is equal to the amount of charge (q) between two plates divided by the voltage (V), if the charge on the gate decreases, so does the inter-electrode capacitance from the gate electrode to the drain electrode ($C_{GD}$). Reduction in gate charge has several benefits. First, the gates may be driven on and off faster with a given gate drive setup, with improvements in switching times. Capacitance generally limits the speeds at which the voltages within a circuit cart swing, owing to finite driving impedance or current. Lowering the gate charge also allows for the reduction in the peak gate drive current needed to achieve a given switching speed, allowing the use of larger gate resistances in the same circuit. This could have implications for improved stability against gate oscillations in practical use. When reduced gate charge devices are operated at lower gate voltages, the penalty in switching times is lower than for a higher gate charge device with the same transconductance and threshold voltage. In transistors, transconductance is the ratio of a change in current (dI/dt) with respect to a change in voltage (dV/dt). In a field effect transistor, transconductance is the ratio of drain to source current ($I_{DS}$/dt), with respect to a change in gate to source voltage ($dV_{GS}$/dt). The threshold voltage is the lowest gate-to-source voltage $V_{GS}$ of a FET that causes current flow in the source-to-drain channel.

The reduction in gate-drain $C_{GD}$ capacitance will result in lower dV/ dt related spikes on the gate of the device, which can accidentally turn the device on, leading to excessive heating and possible destruction of the device. Since the gate to drain capacitance ($C_{GD}$) is amplified by the Miller effect during switching, this parasitic capacitance also amplifies problems stemming from propagation delays transmitting gate signals down long sections of resistive polysilicon gate material. The Miller effect is the phenomena by which an effective feedback path between the input and output of an electronic device is provided by the inter-electrode capacitance of the device. This can effect the total input admittance of the device, which results in the total dynamic input capacitance of the device being always equal to or greater than the sum of the static electrode capacitances.

The trade-off relationship between conduction and turn-off losses can be enhanced in IGBTs by using narrow poly openings and wider poly gates. This creates a device with larger input capacitance and especially high gate-drain capacitance $C_{GD}$-. These devices can become prone to various forms of oscillatory behavior, unless the $C_{GD}$ is reduced.

Prior art solutions include thick oxide gate layers, terraced gates and divided gates. Each solution will be discussed separately.

The present invention includes a power MOS device comprising, a MOS semiconductor substrate layer having one or more source regions and one or more drain regions, a gate insulator covering the semiconductor substrate, characterized in that a conductive gate on said gate insulator, a channel underneath the gate and between a source region and a drain region for passing current between the source and the drain when a voltage is applied to the gate, a means for reducing a capacitance between the gate and drain.

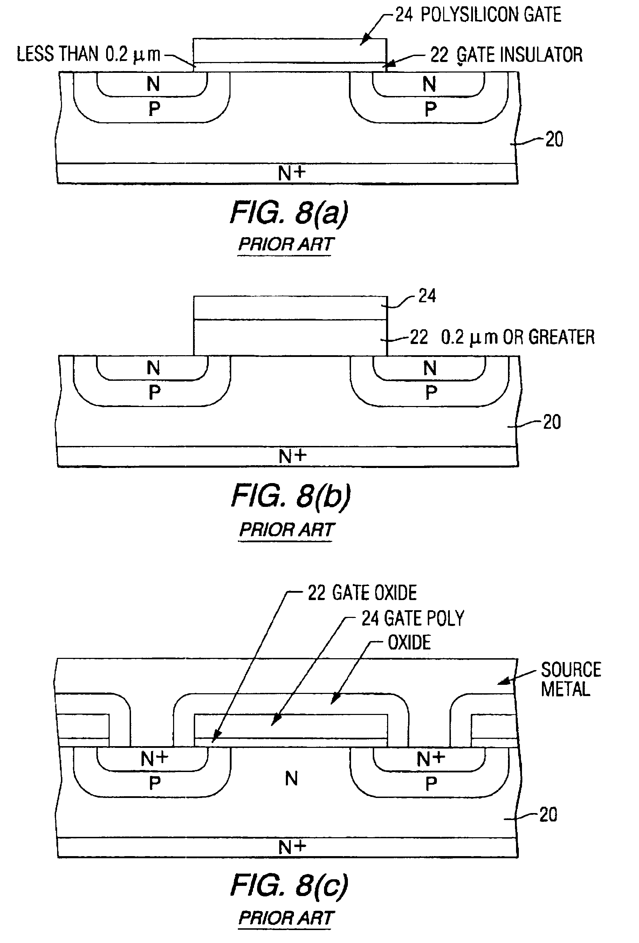

In a MOSFET, a metal or polycrystalline gate is insulated by silicon oxide ($SiO_2$) (oxide for short) or silicon nitride (SiN) from the channel and the rest of the transistor (semiconductor substrate). I have discovered that the use of thicker oxides (or silicon nitride) lowers both the gate-source capacitance $C_{GS}$ and gate-drain capacitance $C_{GD}$. Fig. 8(a) depicts a MOS gate structure using a thinner layer of silicon oxide insulator 22 as used in the prior art. A layer of polysilicon 24 forms the gate and is layered over the insulator 22 (gate oxide). Because the silicon oxide insulator 22 insulates the polysilicon gate 24 from a semiconductor substrate 20 located at the bottom, it is also called the "gate oxide."

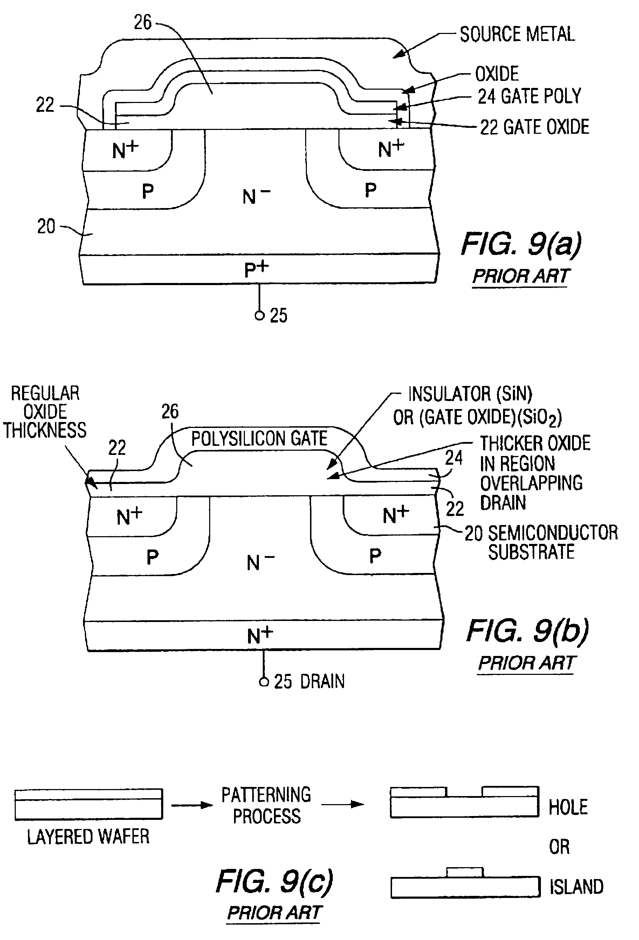

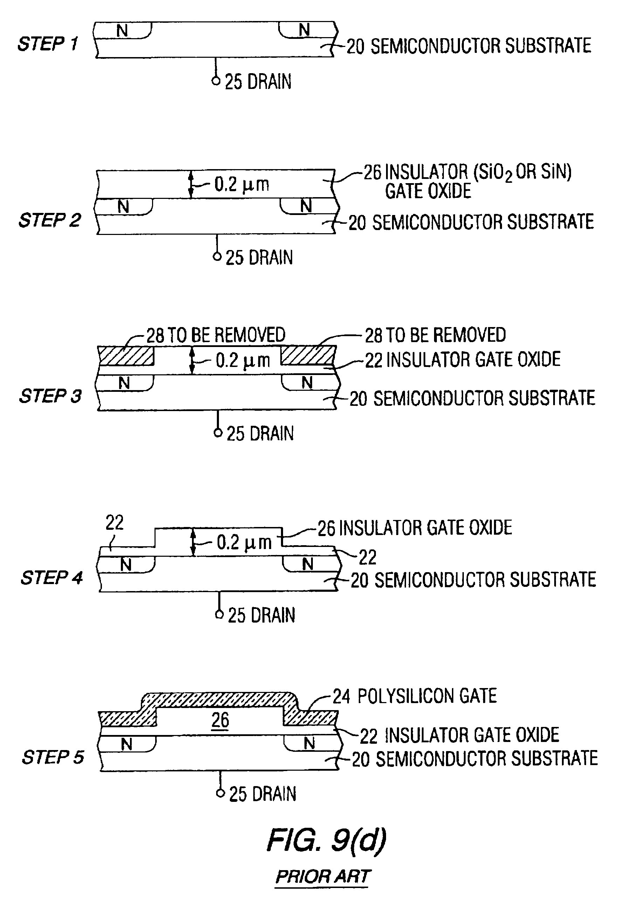

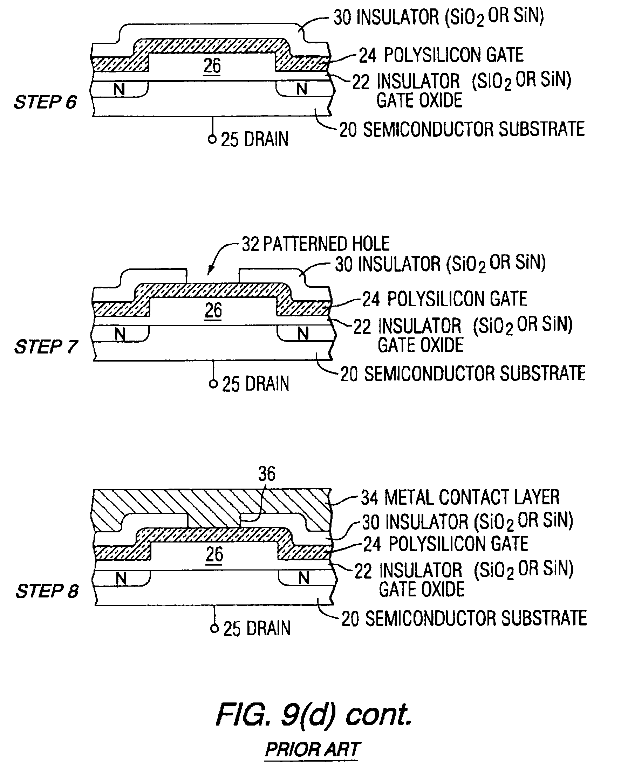

The use of a thicker oxide layer 22 is shown in Fig. 8(b). Note how the polysilicon gate 24 and the semiconductor substrate 20 is identical to that shown in Fig. 8(a). A diagram of thin insulating silicon oxide layer is shown in Fig. 8(c). Fig.9, to be discussed in more detail in the next section, is a diagram of a gate structure to an MOS device having a thicker layer of insulating silicon oxide (or SiN) over the drain area. As seen in Fig. 8(c), to fabricate the device a thick layer of silicon oxide gate insulation 22 of at least .2 μm in thickness is placed over a semiconductor substrate 20. The semiconductor substrate 20 has at least one or more sources and one or more drains (which are well-known in the art and are not shown for purposes of simplifying the diagram). Over this, a polysilicon gate layer 24 is formed.

Fig. 9(a) is a diagram of a MOS transistor with a terraced gate structure. As noted, the gate oxide 22 (that serves as an insulator from the rest of the semiconductor substrate) is thicker under the area of the drain 25. Fig. 9(a) is of an IGBT cell structure, but the technique is equally applicable to all MOS devices. Fig. 9(b) is a schematic diagram of a MOS device with a terraced insulating silicon oxide 22 (or silicon nitride). As shown in Figs. 9(a) and 9(b), adding a terrace 26 to the gate oxide 22 incorporates the use of a thicker gate oxide in the region overlapping the drain 25. The thicker the terrace oxide 26, the lower the gate to drain capacitance ($C_{GD}$). In the preferred embodiment, the terrace gate oxide 26 is at least about .2 micrometers thick in the area overlapping the drain.

To construct the terraced gate oxide 22 (or any semiconductor structure for that matter), a technique of depositing, patterning, doping and heat treatment is utilized. Depositing is the operation used to add thin layers to a wafer surface. One layer is placed upon another, which is placed yet upon another. These layers are either insulators, semiconductors, or conductors. These layers are deposited using one of two major techniques: growing or deposition. After each layer, patterning takes place. Patterning is the series of steps that result in the removal of selected portions of the added surface layers. It includes the steps of forming a mask on a layer and selectively removing portions of the layer that are exposed by the mask. After removal, a pattern of the mask is left on the wafer surface. The material removed may be in the form of a hole or an island. Patterning a layer to produce a hole or an island is shown in Fig. 9(c). The patterning process includes photomasking, masking, photolithography and microlithography. The goal of the patterning operation is to create in or on the wafer surface the parts of the circuit in the exact dimensions required by the circuit design. Some of the layers that are made of semiconductor material will then be doped. Doping is the process of adding specific amounts of dopant (sometimes called "impurities") in the wafer surface. The purpose of doping is to form either N-type or P-type regions in the wafer surface. Doping is carried out using the processes of thermal diffusion and ion implantation.

The invention also includes a method of fabricating a power MOS device comprising forming a plurality of source regions in one surface of the substrate and a drain region in the other surface, depositing a layer of gate insulation on the semiconductor substrate, depositing a layer of conductive gate material over the semiconductor substrate, characterized by selectively removing portions of the conductive gate material layer in a region between the channel and overlapping the drain so as to form a divided silicon gate, selectively removing portions of the conductive gate layer from regions beyond the channels and overlapping the drain so as to leave a middle section of the gate material above the drain.

As seen in Fig. 9(d), in step 1, a drain 25 is formed on the back surface of a semiconductor substrate. On the front or top surface a thick layer of gate insulation 22 of approximately .2 micrometers in thickness is then deposited. As seen in step 3, the gate insulation layer 22 is then patterned so that the insulating material is thinned at its ends. This makes the insulation gate oxide layer 22 thicker in the middle (terrace oxide 26) in the area over the drain 25, and thinner on the two ends, as seen in step 4. In step 5, a polysilicon gate layer 24 is deposited, doped to be conductive, and patterned to form the gate. On top of that, as seen in step 6, a second layer of insulation 30 is placed. As seen in step 7, a hole 32 is patterned in the second layer of insulation over the area of the thicker area of the gate oxide layer 22. As seen in step 8, a metal contact layer 34 is laid on top of the second layer of insulation 30 and into the patterned hole 32, forming a via 36 to the polysilicon gate. A via is a vertical opening filled with conducting material used to connect circuits on various layers of the device to one another and to the semiconducting substrate. The via 36 allows for the application of a voltage to the polysilicon gate.

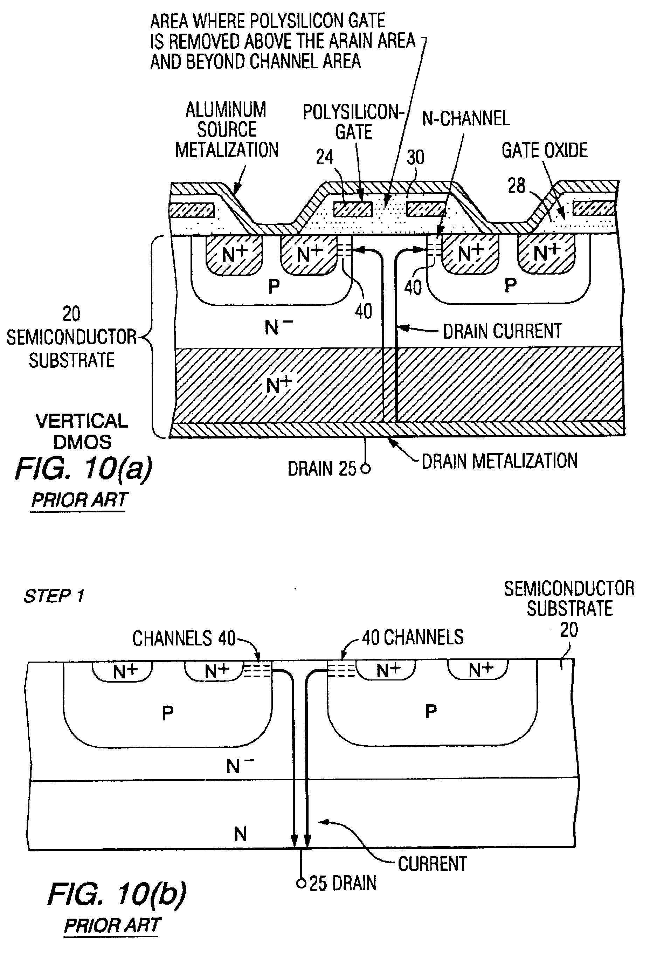

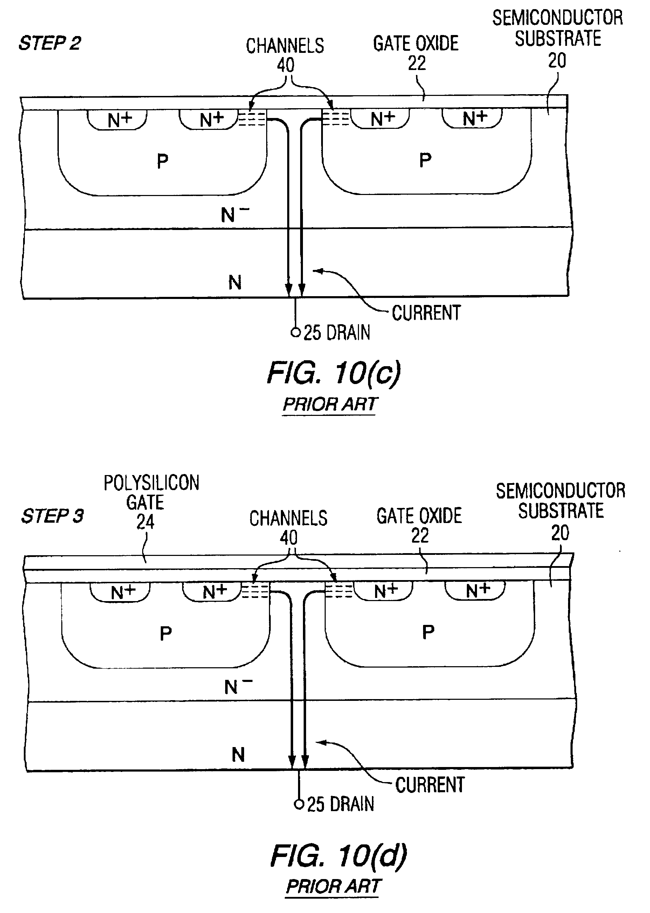

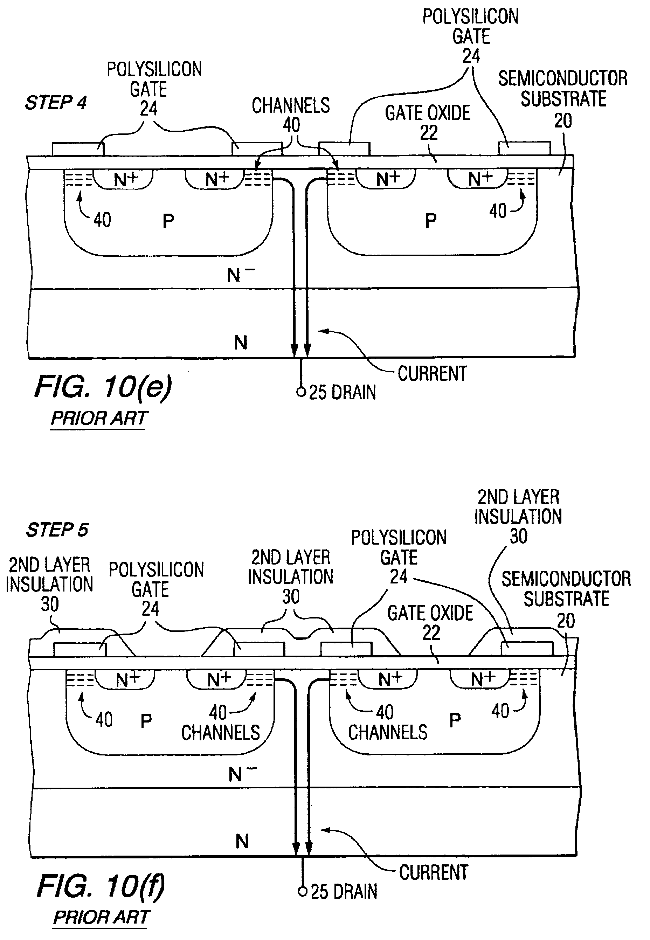

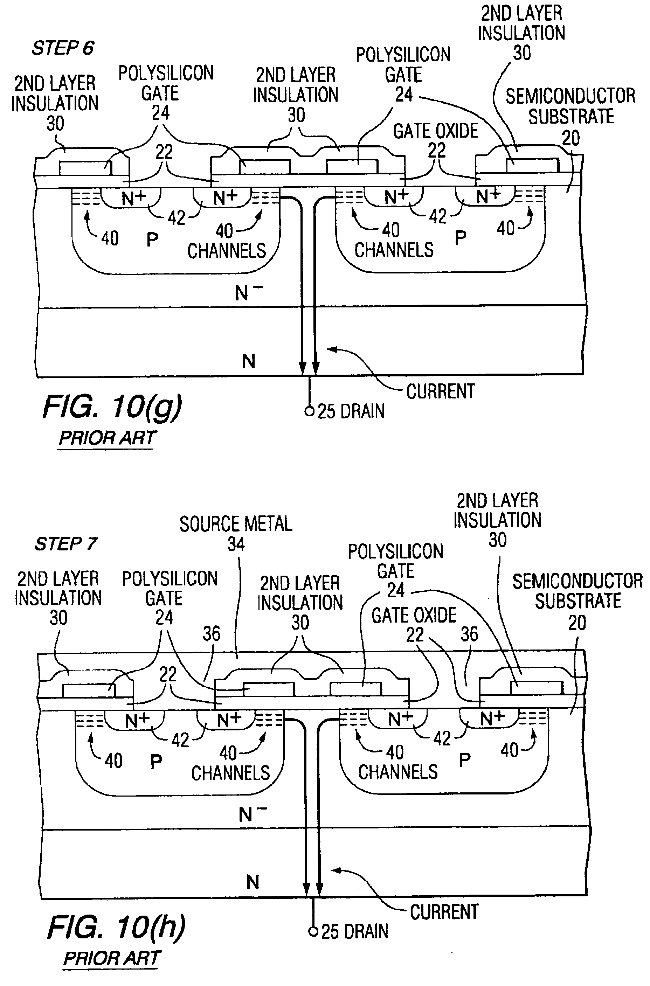

Fig. 10(a) is a diagram of a vertical DMOS device with a divided gate. The divided gate structure is applicable to all power MOS device technology. The polysilicon gate is etched out in the region which is between the two channels 40 and overlaps the drain 25, so as to leave two smaller polysilicon regions 24 (the divided gate) substantially over each channel 40. In addition, the polysilicon 24 is substantially removed from the area above the drain. It is removed by a masking and etching process. The etching may be either a wet or dry etch.. The divided gate reduces the $C_{GD}$ contribution of this region to zero.

Figs. 10(b)- 10(h) show the steps performed in the fabrication of the divided gate. First, as seen in step 1 of Fig. 10(b), the semiconductor substrate is fabricated in a conventional manner to have the double diffused N source regions in P wells and the back side N drain. In Fig 10(c), a thin gate oxide layer 22 is applied. In Fig. 10(d), a polysilicon layer 24 is deposited and then doped to be conductive. In Fig. 10(e), the polysilicon layer 24 is etched out in the region which is between the channels 40 and the drain 25. In Fig. 10(f), a second layer of insulation 30 is added. In Fig. 10(g), the polysilicon gate layer 24, the second layer of insulation 20, and the gate oxide 22 are etched in the area above the source 42. A metal contact layer 34 is added in Fig. 10(h), forming vias 36.

Lower gate charge/capacitance is achieved without the drawbacks of the prior art systems by using a segmented gate. The segmented gate is formed by etching a small section of the polysilicon layer beyond the channel region in order to form three areas of polysilicon, two areas of polysilicon forming gates above the channel and the third area of polysilicon being in the areas substantially overlapping the drain. The middle polysilicon provides a grounded field shield.

The present invention will, now be described, by way of example, with reference to the accompanying drawings in which:

Fig. 1 shows the symbol for a FET transistor.
Fig. 2 is front, perspective view of a horizontal MOSFET.
Fig. 3 is a front, perspective view of a horizontal MOSFET equipped with source contacts, drain contacts, and gate contacts.
Fig. 4 shows the double diffusion process.
Fig. 4(a) shows the diffusion of P impurities (or dopant) in the double diffusion process.

Fig. 4(b) shows the diffusion of N impurities (or dopant) in the double diffusion process.

Fig. 5 is a cross sections of MOS devices.

Fig. 5(a) is a cross section of horizontal n-channel MOSFET.

Fig. 5(b) is a cross section of horizontal n-channel DMOS.

Fig. 6 is a cross section of a vertical n-channel DMOS device.

Fig. 7(a) is a perspective view of a cross section of an IGBT.

Fig. 7(b) is the symbol for an IGBT.

Fig. 8(a) depicts a MOS gate structure using a thinner layer (less than about .2 μm) of silicon oxide insulator 22 as used in the prior art.

Fig. 8(b) depicts a MOS gate structure using a thicker layer (at least about .2 μm) of silicon oxide insulator.

Fig. 8(c) is a diagram of thin insulating silicon oxide layer.

Fig. 9(a) is a diagram of a MOS transistor with a terraced gate structure.

Fig. 9(b) is a schematic diagram of a MOS device with a terraced insulating silicon oxide.

Fig. 9(c) shows patterning a layer to produce a hole or an island.

Fig. 9(d) shows the steps in the fabrication process to make a terraced gate oxide structure.

Fig. 10(a) is a diagram of a MOS device (here a vertical DMOS) with a divided gate.

Fig. 10(b)-10(g) shows the steps performed in the fabrication of the divided gate.

Fig. 11(a) is a schematic of a segmented 3-port gate structure.

Fig. 11(b) is a schematic of a vertical DMOS with a segmented 3-port gate structure.

Fig. 11(c) shows the steps performed in the fabrication of a segmented 3-port gate structure.

Fig. 12 is a top view of how a segmented gate structure may be laid out in practice.

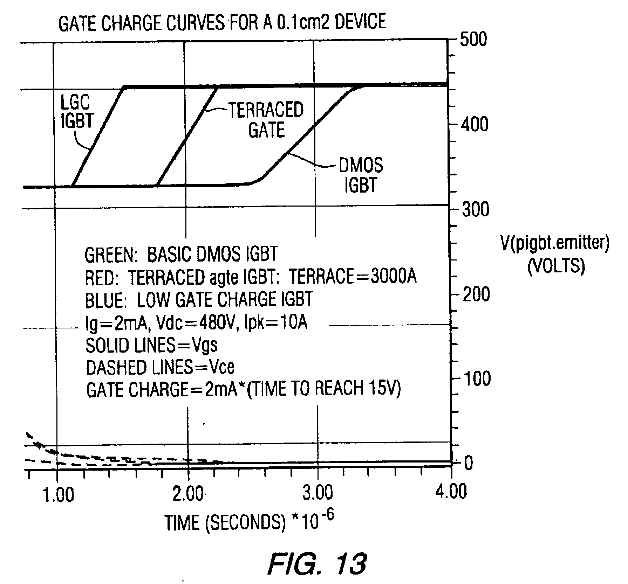

Fig. 13 shows the gate charge curves for the structures in the table of Fig. 13.

Fig. 14 is a graph that shows turn-on curves for various gate-to-drain capacitance reducing structures with the same freewheeling diode and gate circuit

Fig. 15 shows the turn-off curves for various gate-to-drain capacitance reducing structures.

Fig. 16 shows comparative tests on LGG and SMPS IGBTs.

Fig. 17 shows comparative capacitance curves for LGC and SMPS IGBTs.

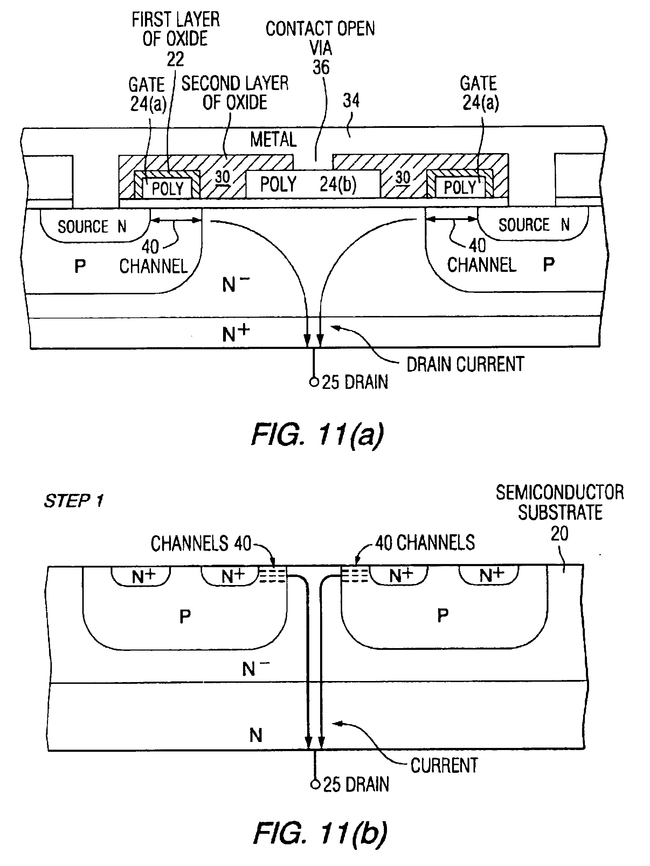

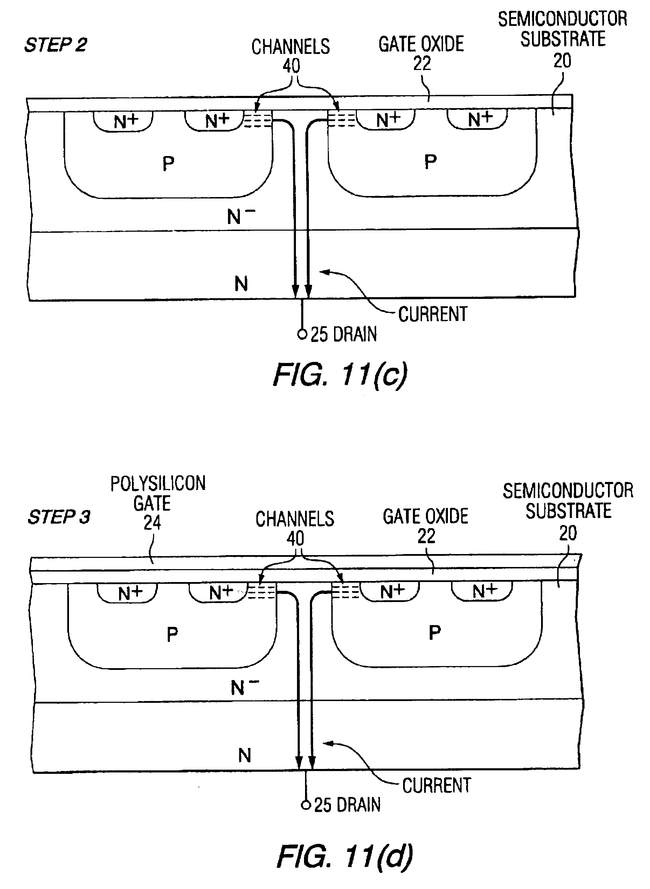

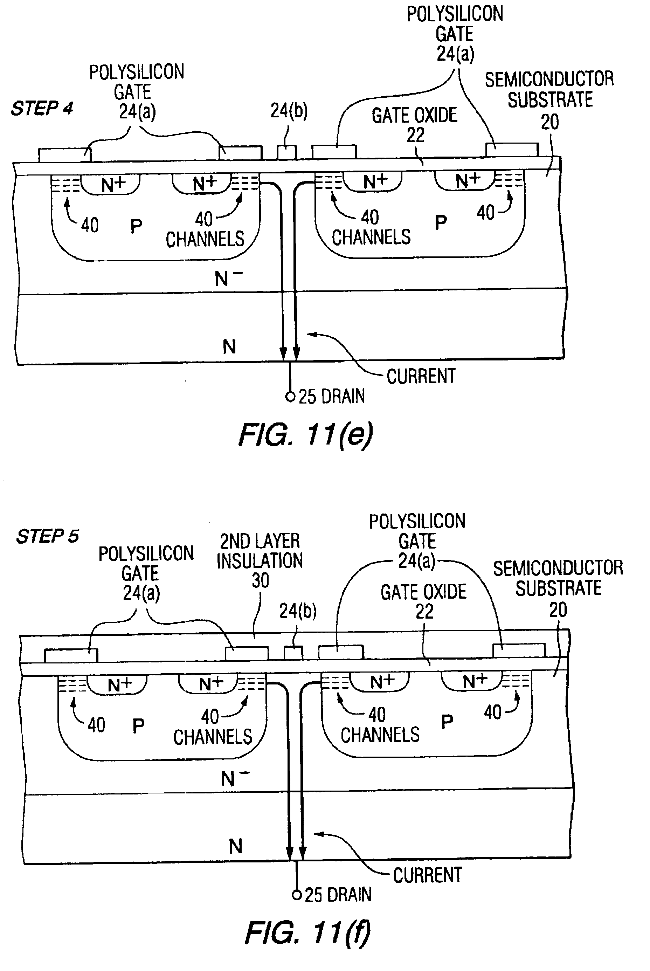

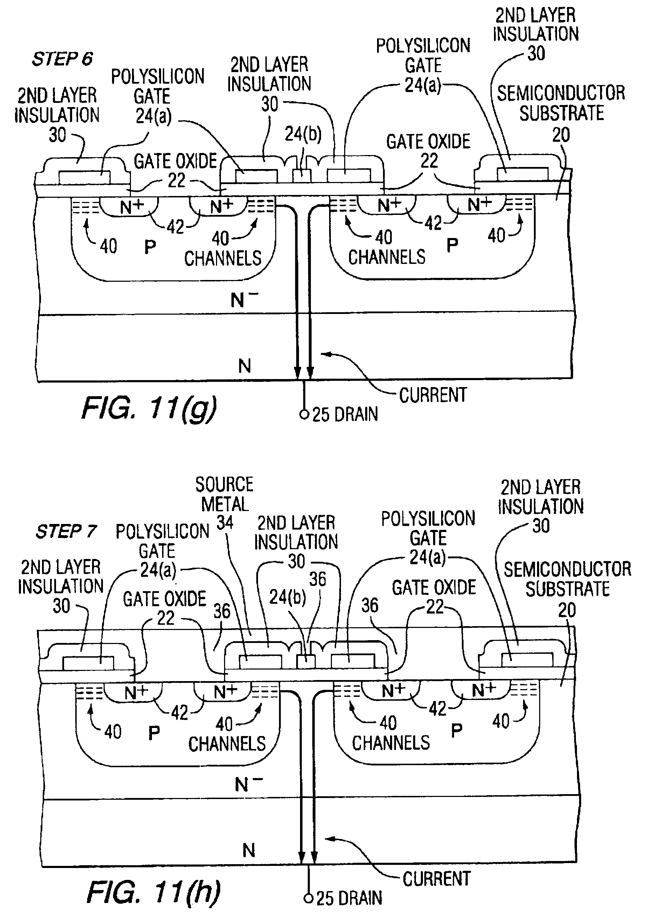

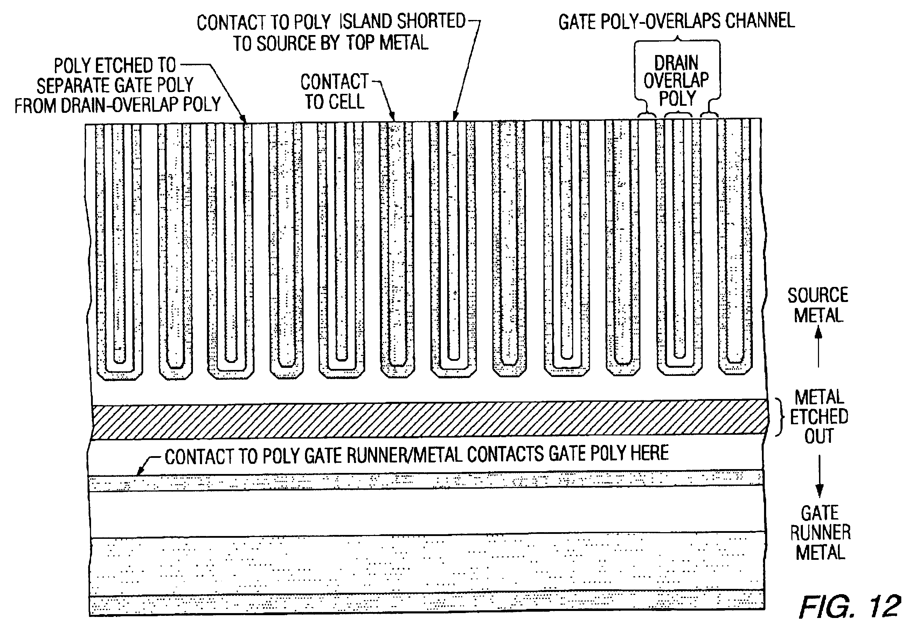

Turning to Figure 11(a), there is shown how etching small sections of some of the polysilicon gate that are beyond the channel region leaves three areas of polysilicon 24. Two areas form gates 24(a) above the channel and a a third area 24(b) forms a central gate in the region substantially overlapping the drain 25. The central polysilicon region 24(b) is then shorted to the source via a contact opening 36. The $C_{GD}$ contribution from the area of polysilicon etched out is reduced to zero, and the loss in breakdown is minimized by having the polysilicon separated from die silicon by the thickness of the thin gate oxide. Note how the central polysilicon gate 24(b) is electrically coupled to the source through the metal contact area 34. Fig. 11(b) shows a vertical DMOS device with the segmented gate structure. Fig. 12 shows a top view of how such a device may be laid out in practice.

Fig. 11(c) shows the process for making a segmented structure. First, as seen in step 1, the semiconductor substrate 20 includes the N sources in the P wells and the N+ layer that forms the drain. In step 2, a thin gate oxide layer 22 is applied. In step 3, a polysilicon gate layer 24 is deposited. In step 4, the small section of layer 24 is etched out in the two regions which are just beyond the channels 40 and overlap the drain 25. Instead of removing all the material, as was the case of the divided gate previously discussed, a middle section of polysilicon 24(b) is left in the area above the drain. In step 5, a second layer of insulation 30 is added. In step 6, the second insulation layer 30 and gate oxide 22 are etched in the area above the source 42, and the area above the middle gate 24(b). A metal contact layer 34 is added in step 7, forming vias 36.

Fig. 12 is a table that summaries the results from simulations of the devices described above, and how they minimize gate charge. All the simulations center around the basic DMOS IGBT cell shown in Fig. 11. The terraced gate cells correspond to Fig. 8, where the terrace oxide thickness is varied. The etched poly cells correspond to Fig. 10.

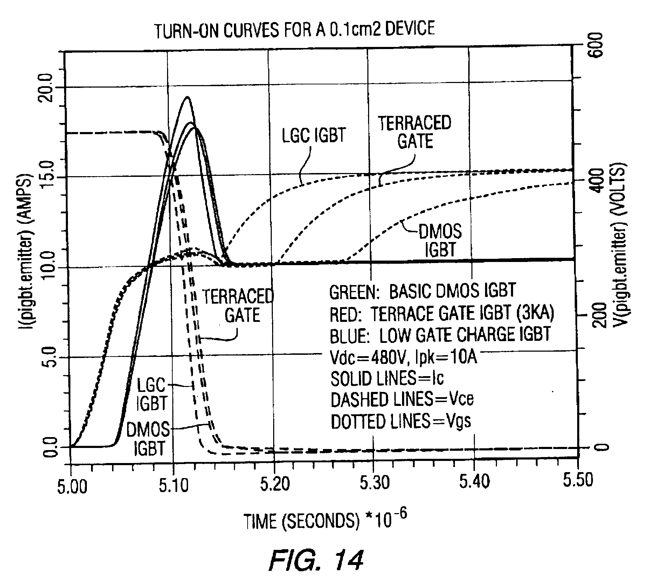

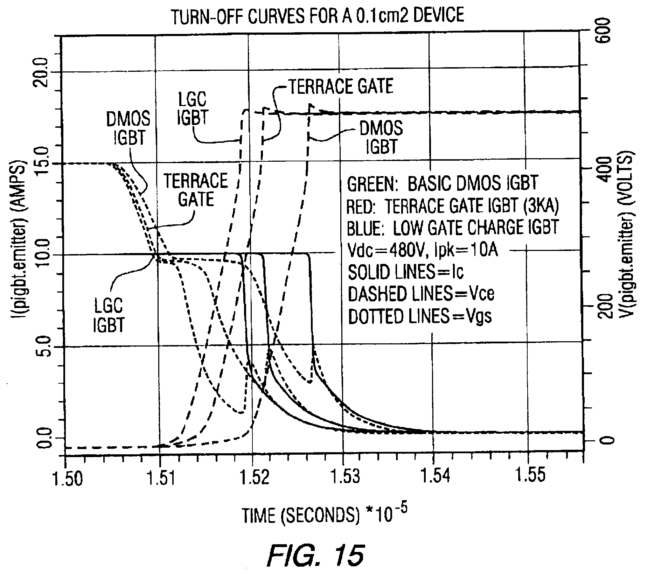

Table 1 shows the gate charge curves for the structures in the table above. The improved performance of the low gate charge device is dear. Fig. 14 shows turn-on curves for the above structures with the same freewheeling diode and gate circuit. It is dear that the low gate charge cell has the fastest turn-on, that its gate voltage reaches its final value fastest, and it has the lowest "dynamic saturation" of all the structures. Fig. 15 shows the turn-off curves, where the turn-off delay time is seen to be much reduced for the low gate charge device.


## Table 1

| | Fig. 11(a) 3 port-gate | Fig. 11(a) 3 port-gate | Fig 9(a) Terraced Gate | Fig 9(a) Terraced Gate | Fig. 10 Divided Gate | Basic IGBT Device without Invention |
|---|---|---|---|---|---|---|
| | Low gate charge Etch 1um | Low gate charge Etch 1.5 um | Terraced gate terrace 3KA | Terraced gate terrace 5KA | Etched Poly | Basic |
| BV (Volts) | 685 | 672 | 672 | 649 | 542 | 699 |
| $V_{CESAT}$ (Volts) | 1.366 | 1.366 | 1.354 | 1.358 | 1.363 | 1.356 |
| $C_{GD}$ nF/cm² | 7.89 | 7.89 | 14.46 | 11.83 | 7.89 | 34.5 |
| $Q_{GATE}$ NC/cm² | 29 | 29 | 45 | 42 | 29 | 65 |

The simulation uses one cell and multiplies the current by the number of cells in the actual 0.1 CM2 device. In practical devices, there is a propagation delay between cells, or along the length of a long stripe cell, due to the fact that the polysilicon gate material is resistive. This propagation delay is determined by the resistivity of the polysilicon layer, and the capacitance between the gate layer and source/drain regions. Reducing the capacitance which couples the gate to the source/drain regions helps to cut down the propagation delay, allowing faster turn-on and turn-off times. In this respect, the low gate charge cell shown in Fig. 4 again provides the greatest improvement.

The low gate charge cell is thus shown to offer the most improvement in reduced gate-charge, $C_{GD}$, and switching speed, with minimal degradation in breakdown voltage, no change in on-state drop and no extra process steps. It is important to note that the degree to which the gate charge, and especially $C_{GD}$, can be reduced by this technique is limited only by lithographic and etch capability. With smaller etched out regions, the degradation in BV can be made even smaller. With better alignment and etch capability, the extension of the poly over the channel can be minimized, reducing both the overall input capacitance and the CGD to virtually zero.

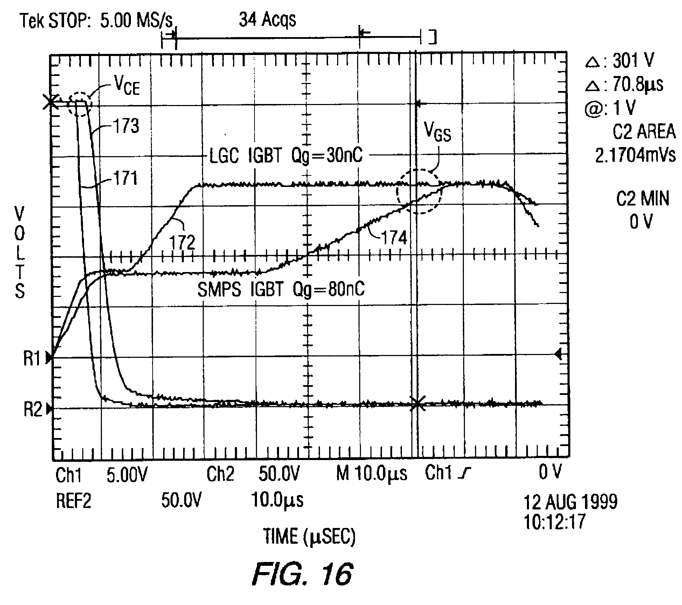

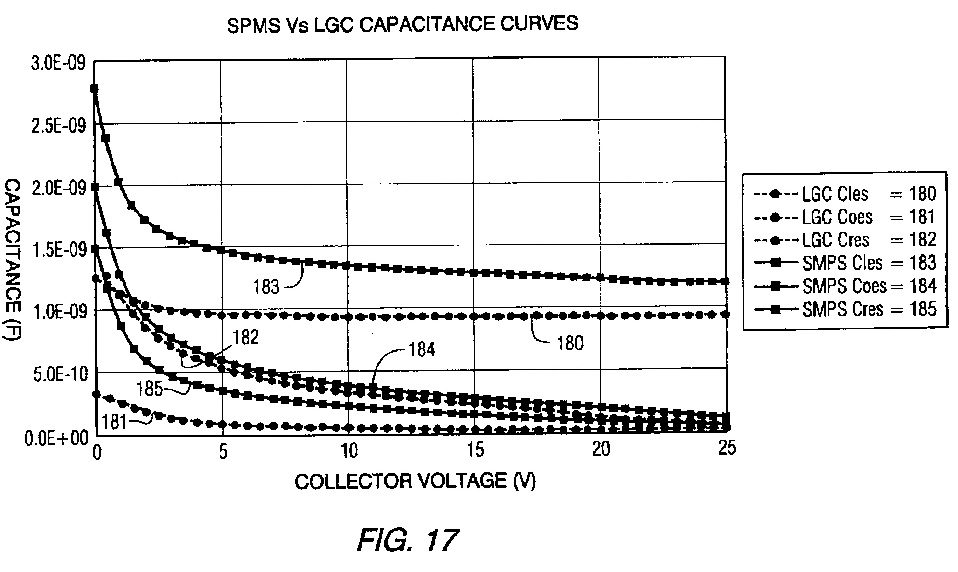

Tuning to Figures 16 and 17, there are shown comparative curves of a conventional IGBT (SMPS) and a low gate charge (LGC) IGBT of the invention. Figure 17 shows the results of current tests on the LGC and SMPS devices. During the tests a constant current was fed to the gate and the voltage across the devices (Vce) and between the gate and source (Vgs) were recorded as a function of time. The figure shows two pairs of traces, one pair for Vce and the other for Vgs. Traces 171 and 172 are for the LGC device; traces 173 and 174 are for the SMPS device. Both devices are fabricated identically and have the same die size. The only difference between them is the configuration of their respective gates. The SMPS has a conventional gate and the LGC has a segmented gate in accordance with the present invention. As current enters the gates, both devices turn on, with the LGC turning on faster than the SMPS. The Vgs values begin to rise and then plateau. The plateau for the LGC is of a shorter time duration -00 .0 than the plateau for the SMPS. The length of the plateau corresponds to the charge. The LGC has a charge of about 30 nanoCoulombs; the SMPS has a charge of about 80 nanoCoulombs. The present invention represents an improvement of about 60% over the prior art. Stated another way, the charge on the SMPS is almost three times as large as the charge on the LGC.

Figure 17 compares the input capacitance (Cies), the output capacitance (Coes) and the reverse capacitance (Cres) of the LGC and the SMPS. At Vc = 0, the input capacitance of the LGC is about 50% of the capacitance of the SMPS. Stated another way, the prior art SMPS has about twice the input capacitance of the LGC.

A power MOS device is provided that reduces gate to drain capacitance $C_{GD}$ by (1) the use of thicker gate oxides of at least about .2 micro-meters; (2) using a terraced gate oxide; (3) etching out the polysilicon from the drain overlap area, so as to leave two smaller polysilicon regions substantially over the channel, but not in the area above the drain; or (4) etching a small section of the polysilicon beyond the channel region so as to leave three areas of polysilicon, two forming gates above the channel and the third being in the areas overlapping the drain.

## Claims

1.   A power MOS device comprising, a MOS semiconductor substrate layer having one or more source regions and one or more drain regions, a gate insulator covering the semiconductor substrate, characterized in that a conductive gate on said gate insulator, a channel underneath the gate and between a source region and a drain region for passing current between the source and the drain when a voltage is applied to the gate, a means for reducing a capacitance between the gate and drain.

2. A power MOS device as claimed in claim 1 characterized in that the gate comprises polycrystalline silicon, the gate insulating layer comprises silicon oxide to form a insulating gate oxide layer, and in which the power MOS device is chosen from the group consisting of a vertical MOSFET, a vertical DMOS, or an IGBT.

3. A power MOS device as claimed in claim 1, characterized in that the means for reducing a capacitance between the gate and drain comprises a layer of gate insulating material on the substrate and three segments of conductive gate material on the insulating layer, said three segments comprising a central segment and two end segments, said central segment being electrically isolated from said two end segments.

4. A power MOS device as claimed in claim 3 characterized in that the central segment is wider than either end segment, and the central segment is electrically coupled to the source.

5. A method of fabricating a power MOS device comprising forming a plurality of source regions in one surface of the substrate and a drain region in the other surface, depositing a layer of gate insulation on the semiconductor substrate, depositing a layer of conductive gate material over the semiconductor substrate, characterized by selectively removing portions of the conductive gate material layer in a region between the channel and overlapping the drain so as to form a divided silicon gate, selectively removing portions of the conductive gate layer from regions beyond the channels and overlapping the drain so as to leave a middle section of the gate material above the drain.

6. A method of fabricating a power MOS device as claimed in claim 5 characterized, by depositing a second layer of insulation over the conductive gate regions and exposed thin gate insulating layer, etching the second insulation layer and the gate oxide in the areas above the source and above the central gate section to form vias, depositing a metal contact layer over the second insulation layer and into the vias to form art electrical connection between the source and the central gate region.

A. *n-channel MOSFET*          B. *p-channel MOSFET*

# FIG. 1
## PRIOR ART

GATE

INSULATION (SiO$_2$)

DRAIN

SOURCE

n
S

p

n
D

"BODY" OR
"SUBSTRATE"

CONDUCTING n-TYPE REGION
FORMS HERE WHEN GATE IS
BROUGHT POSITIVE
(THE CHANNEL)

MOSFET
# FIG. 2
## PRIOR ART

SOURCE CONTACT

GATE CONTACT

DRAIN CONTACT

SOURCE

N+

SILICON
DIOXIDE

P

N+

P-TYPE SILICON
SUBSTRATE

DRAIN

MOSFET WITH
SOURCE, GATE & DRAIN
CONTACTS

*FIG. 3*
*PRIOR ART*

DIFFUSION OF
P IMPURITIES

OXIDE

P

N⁻

*FIG. 4(a)*

DIFFUSION OF
N IMPURITIES

OXIDE

N⁺

N⁺

P

L

L'

N⁻

*FIG. 4(b)*

DOUBLE-DIFFUSED METAL-OXIDE SEMICONDUCTOR PROCESS.

*FIG. 4*
*PRIOR ART*

SOURCE  GATE ELECTRODES  DRAIN

N+          N+

PASSIVATING OXIDE

P SUBSTRATE

CROSS SECTION OF N-CHANNEL
MOSFET

*FIG. 5(a)*

DRAIN

SOURCE  GATE ELECTRODES

P          N+          N+

CHANNEL          DRIFT REGION

N SUBSTRATE

CROSS SECTION OF N-CHANNEL
D/MOS TRANSISTOR

*FIG. 5(b)*

*FIG. 5*
*PRIOR ART*

ALUMINUM
SOURCE
METALIZATION          POLYSILICON-
GATE          N-CHANNEL          GATE OXIDE

N+     N+          N+     N+

P                    P

N⁻          DRAIN CURRENT

N+

VERTICAL
DMOS
*FIG. 6*
*PRIOR ART*

DRAIN METALIZATION

10

CHANNEL

DRAIN

GATE POLYSILICON
CHANNEL
OXIDE

N+

N+

P—

N+

P+

N—

N+

N+

P+

EPI
BUFFER
SUBSTRATE
COLLECTOR

*FIG. 7(a)*
PRIOR ART

COLLECTOR

GATE

EMITTER

*FIG. 7(b)*
PRIOR ART

**FIG. 8(a)**
_PRIOR ART_

**FIG. 8(b)**
_PRIOR ART_

**FIG. 8(c)**
_PRIOR ART_

26 ——
SOURCE METAL
—— OXIDE
22 ——
24 GATE POLY
—— 22 GATE OXIDE

N$^+$        N$^+$

P        N$^-$        P

20

P$^+$

○ 25

**FIG. 9(a)**
_PRIOR ART_

REGULAR OXIDE THICKNESS

26

INSULATOR (SiN) OR (GATE OXIDE)(SiO$_2$)

POLYSILICON GATE

22

THICKER OXIDE IN REGION OVERLAPPING DRAIN

24

22

N$^+$        N$^+$

P        N$^-$        P

20 SEMICONDUCTOR SUBSTRATE

N$^+$

○ 25 DRAIN

**FIG. 9(b)**
_PRIOR ART_

LAYERED WAFER → PATTERNING PROCESS →

HOLE

OR

ISLAND

**FIG. 9(c)**
_PRIOR ART_

STEP 1    N                    N
                                    20 SEMICONDUCTOR SUBSTRATE
                    25 DRAIN

STEP 2                  0.2 μm       26 INSULATOR (SiO₂ OR SiN)
                                        GATE OXIDE
          N                    N
                                    20 SEMICONDUCTOR SUBSTRATE
                    25 DRAIN

STEP 3    28 TO BE REMOVED        28 TO BE REMOVED
                  0.2 μm             22 INSULATOR GATE OXIDE
          N                    N
                                    20 SEMICONDUCTOR SUBSTRATE
                    25 DRAIN

STEP 4    22                       26 INSULATOR GATE OXIDE
                  0.2 μm
          N                    N    22
                                    20 SEMICONDUCTOR SUBSTRATE
                    25 DRAIN

STEP 5                             24 POLYSILICON GATE
                  26
          N                    N    22 INSULATOR GATE OXIDE
                                    20 SEMICONDUCTOR SUBSTRATE
                    25 DRAIN

## FIG. 9(d)

PRIOR ART

STEP 6

30 INSULATOR (SiO$_2$ OR SiN)

24 POLYSILICON GATE

26

22 INSULATOR (SiO$_2$ OR SiN) GATE OXIDE

N        N

20 SEMICONDUCTOR SUBSTRATE

25 DRAIN

STEP 7

32 PATTERNED HOLE

30 INSULATOR (SiO$_2$ OR SiN)

24 POLYSILICON GATE

26

22 INSULATOR (SiO$_2$ OR SiN) GATE OXIDE

N        N

20 SEMICONDUCTOR SUBSTRATE

25 DRAIN

STEP 8

36

34 METAL CONTACT LAYER

30 INSULATOR (SiO$_2$ OR SiN)

24 POLYSILICON GATE

26

22 INSULATOR (SiO$_2$ OR SiN) GATE OXIDE

N        N

20 SEMICONDUCTOR SUBSTRATE

25 DRAIN

# FIG. 9(d) cont.

PRIOR ART

AREA WHERE POLYSILICON GATE
IS REMOVED ABOVE THE ARAIN AREA
AND BEYOND CHANNEL AREA

ALUMINUM
SOURCE
METALIZATION

POLYSILICON-
GATE
24

N-CHANNEL

30

GATE OXIDE

28

N+   N+   N+   N+

P        P

40        40

N−

DRAIN CURRENT

20
SEMICONDUCTOR
SUBSTRATE

N+

VERTICAL
DMOS
*FIG. 10(a)*
*PRIOR ART*

DRAIN 25 ○    DRAIN METALIZATION

*STEP 1*

SEMICONDUCTOR
SUBSTRATE
20

CHANNELS 40    40 CHANNELS

N+   N+        N+   N+

P              P

N−

N

CURRENT

*FIG. 10(b)*
*PRIOR ART*

○ 25 DRAIN

STEP 2

CHANNELS
40

GATE OXIDE
22

SEMICONDUCTOR
SUBSTRATE
20

N+    N+    N+    N+

P    P

N⁻

N

CURRENT

○25 DRAIN

## FIG. 10(c)
### PRIOR ART

STEP 3

POLYSILICON
GATE
24

CHANNELS
40

GATE OXIDE
22

SEMICONDUCTOR
SUBSTRATE
20

N+    N+    N+    N+

P    P

N⁻

N

CURRENT

○25 DRAIN

## FIG. 10(d)
### PRIOR ART

POLYSILICON
GATE
24

*STEP 4*

POLYSILICON
GATE
24

CHANNELS
40

GATE OXIDE
22

SEMICONDUCTOR
SUBSTRATE
20

N+    N+    N+    N+

40    P    40    P    40

N−

N

CURRENT

25 DRAIN

## FIG. 10(e)
*PRIOR ART*

*STEP 5*

2ND LAYER
INSULATION
30

POLYSILICON
GATE
24

2ND LAYER
INSULATION
30

POLYSILICON
GATE
24

2ND LAYER
INSULATION
30

2ND LAYER
INSULATION
30

POLYSILICON
GATE
24

GATE OXIDE
22

SEMICONDUCTOR
SUBSTRATE
20

N+    N+    N+    N+

40    P    40
CHANNELS
40    P    40
CHANNELS

N−

N

CURRENT

25 DRAIN

## FIG. 10(f)
*PRIOR ART*

STEP 6

FIG. 10(g)
PRIOR ART

STEP 7

FIG. 10(h)
PRIOR ART

FIRST LAYER
OF OXIDE
22

CONTACT OPEN
VIA
36

GATE
24(a)

SECOND LAYER
OF OXIDE

34

GATE
24(a)

METAL

POLY 30 POLY 24(b) 30 POLY

SOURCE N 40 40 SOURCE N

P CHANNEL N⁻ CHANNEL P

N⁺

DRAIN CURRENT

○ 25 DRAIN

**FIG. 11(a)**

STEP 1

SEMICONDUCTOR
SUBSTRATE
20

CHANNELS 40 40 CHANNELS

N⁺ N⁺ N⁺ N⁺

P P

N⁻

N

CURRENT

○ 25 DRAIN

**FIG. 11(b)**

STEP 2

CHANNELS 40     GATE OXIDE 22     SEMICONDUCTOR SUBSTRATE 20

N+    N+    N+    N+

P             P

N$^-$

N

CURRENT

○ 25 DRAIN

## FIG. 11(c)

STEP 3

POLYSILICON GATE 24     CHANNELS 40     GATE OXIDE 22     SEMICONDUCTOR SUBSTRATE 20

N+    N+    N+    N+

P             P

N$^-$

N

CURRENT

○ 25 DRAIN

## FIG. 11(d)

STEP 4

POLYSILICON
GATE
24(a)

24(b)

POLYSILICON
GATE
24(a)

GATE OXIDE
22

SEMICONDUCTOR
SUBSTRATE
20

N+ · N+ · N+ · N+

40 · P · 40
CHANNELS

40 · P · 40
CHANNELS

N⁻

N

CURRENT

○ 25 DRAIN

## FIG. 11(e)

STEP 5

POLYSILICON
GATE
24(a)

2ND LAYER
INSULATION
30

24(b)

POLYSILICON
GATE
24(a)

GATE OXIDE
22

SEMICONDUCTOR
SUBSTRATE
20

N+ · N+ · N+ · N+

40 · P · 40
CHANNELS

40 · P · 40
CHANNELS

N⁻

N

CURRENT

○ 25 DRAIN

## FIG. 11(f)

STEP 6

2ND LAYER INSULATION 30

POLYSILICON GATE 24(a)

2ND LAYER INSULATION 30

24(b)

POLYSILICON GATE 24(a)

2ND LAYER INSULATION 30

SEMICONDUCTOR SUBSTRATE 20

2ND LAYER INSULATION 30

GATE OXIDE 22

GATE OXIDE 22

N+  42  N+  40 CHANNELS  N+  42  N+

40  P  40 CHANNELS  40  P  40

N⁻

N

CURRENT

FIG. 11(g)

25 DRAIN

STEP 7

SOURCE METAL 34

POLYSILICON GATE 24(a)

2ND LAYER INSULATION 30

36

24(b)

POLYSILICON GATE 24(a)

2ND LAYER INSULATION 30

2ND LAYER INSULATION 30

GATE OXIDE 22

36

36

GATE OXIDE 22

SEMICONDUCTOR SUBSTRATE 20

N+  42  N+  40 CHANNELS  N+  42  N+

40  P  40 CHANNELS  40  P  40

N⁻

N

CURRENT

FIG. 11(h)

25 DRAIN

23

POLY ETCHED TO
SEPARATE GATE POLY
FROM DRAIN-OVERLAP POLY

CONTACT TO POLY ISLAND SHORTED
TO SOURCE BY TOP METAL

GATE POLY-OVERLAPS CHANNEL

CONTACT
TO CELL

DRAIN
OVERLAP
POLY

SOURCE
METAL

METAL
ETCHED
OUT

CONTACT TO POLY GATE RUNNER/METAL CONTACTS GATE POLY HERE

GATE
RUNNER
METAL

*FIG. 12*

EP 1 096 573 A2

GATE CHARGE CURVES FOR A 0.1cm2 DEVICE

FIG. 13

TURN-ON CURVES FOR A 0.1cm2 DEVICE

GREEN: BASIC DMOS IGBT
RED: TERRACE GATE IGBT (3KA)
BLUE: LOW GATE CHARGE IGBT
Vdc=480V, Ipk=10A
SOLID LINES=Ic
DASHED LINES=Vce
DOTTED LINES=Vgs

TIME (SECONDS) *10⁻⁶

*FIG. 14*

FIG. 15

*FIG. 16*

EP 1 096 573 A2

FIG. 17

SPMS Vs LGC CAPACITANCE CURVES

Legend:
- - - LGC Cles = 180
- - - LGC Coes = 181
- - - LGC Cres = 182
—— SMPS Cles = 183
—— SMPS Coes = 184
—— SMPS Cres = 185

CAPACITANCE (F) — vertical axis: 0.0E+00, 5.0E-10, 1.0E-09, 1.5E-09, 2.0E-09, 2.5E-09, 3.0E-09

COLLECTOR VOLTAGE (V) — horizontal axis: 0, 5, 10, 15, 20, 25